# EUROPEAN PATENT SPECIFICATION

(11) **EP 0 343 569 B1**
(45) Date of publication and mention of the grant of the patent: **23.03.1994**
(21) Application number: 89109186.0
(22) Date of filing: 22.05.1989
(51) Int. Cl.: H03D 3/24, H03G 11/06

(54) **An FM intermediate-frequency circuit**
FM Zwischenfrequenz-Schaltung
Circuit à fréquence intermédiaire pour modulation de fréquence

(30) Priority: 25.05.1988 FI 882471
(43) Date of publication of application: 29.11.1989
(73) Proprietor: NOKIA MOBILE PHONES LTD., 24101 Salo (FI)
(72) Inventor: Nyqvist, Jouni, SF-25130 Muurala (FI)
(74) Representative: Strehl Schübel-Hopf Groening & Partner

(56) References cited:
- EP-A- 0 060 662
- EP-A- 0 254 339
- PATENT ABSTRACTS OF JAPAN, vol. 8, no. 21 (E-224)[1458], 28th January 1984; & JP-A-58 184 831 (SONY K.K.) 28-10-1983
- TELECOMMUNICATIONS AND RADIO ENGINEERING, vol. 24, no. 12, 1969, pages 126-130; G.M. KRYLOV: "Aspects of the design of an intermediate-frequency logarithmic amplifier"

## Description

The present invention relates to an FM intermediate-frequency circuit into which there is integrated at least a first limiter-amplifier, a level detector, and a phase-locked loop which contains a VCO oscillator, the level detector being incorporated into the limiter-amplifier, to which the intermediate-frequency signal is applied, the output of said limiter-amplifier being connected with the input of the phase-locked loop.

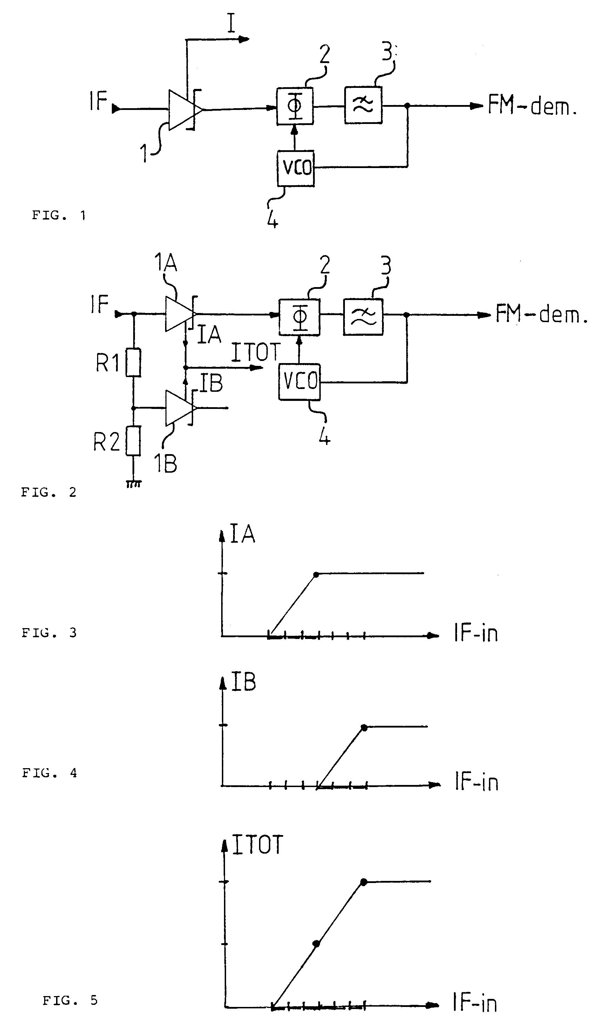

One conventional FM intermediate-frequency circuit is shown in the accompanying Figure 1. The intermediate-frequency signal IF is fed to the limiter-amplifier 1, to which there is also connected a level detector whose output signal is I. The phase detector 2, the loop filter 3, and the VCO 4 form a so-called phase-locked loop; FM demodulation FM-dem is obtained as its output.

Assembling the circuit elements on the same chip in an intermediate-frequency circuit such as this, in which the FM detector is a PLL loop (which is thus made up of a phase detector, a loop filter and a VCO), results in problems for the total amplification of the limiter-amplifier. Excessive amplification will produce detrimental oscillation, i.e. the limiter-amplifier will amplify only the VCO signal, the detection of the incoming signal being prevented. Therefore the maximum usable amplification of the limiter-amplifier is approximately 50-60 dB.

When the level detector is in connection with the limiter-amplifier, its detection capacity is at maximum equal to the amplification of the amplifier chain, i.e. according to the above, 50-60 dB. This is, however, too low for radio telephone applications, for example, since in these the dynamism requirement set on the level detector is typically approximately 75 dB.

There are on the market very few intermediate-frequency circuits in which the FM demodulation of the signal has been implemented by means of a PLL, and usually they do not have level detection of the input signal. If the total amplification of the limiter-amplifier is, for example, over 90 dB, the PLL detector can be implemented in such a way that the VCO is in another circuit, at a sufficient distance from the input of the limiter-amplifier. The condition is thus that the isolation requirement for avoiding oscillation is fulfilled.

There is no precise numerical value for the amplification of the limiter-amplifier. What is most important is that the total amplification of the system is sufficient to bring the last stages of the limiter-amplifier block up to the limit. If the amplification of the limiter-amplifier is "deficient", i.e. it is not limited to its own noise, the lacking amount of amplification must be attended to by amplification of the pre-stages, and vice versa.

A logarithmic amplifier with a large range of input signal magnitude at high frequency is disclosed in EP-A-0 060 662. This amplifier comprises a number of similar stages arranged in cascade, which output signals are summed, and an level dividing input stage to feed a different range of signal amplitudes, derived from the input signal, to the respective stages.

The object of the present invention is to eliminate the above-mentioned problems and to extend the dynamic range of the level detector without using a limiter-amplifier whose amplification would cause detrimental oscillation. In order to achieve this object, the intermediate-frequency circuit according to the invention is characterized in that it has, in parallel with the said limiter-amplifier, at least one other limiter-amplifier, in connection with which there is also a level detector, in which case the level of the input signal of the other limiter-amplifier or other limiter-amplifiers is reduced, by means of a level-dividing circuit, compared with the first limiter-amplifier, and the signals obtained from the level detectors are combined into one level detection signal.

The level-dividing circuit is preferably calibrated so that the operating range of the second limiter-amplifier begins at that level of the intermediate-frequency signal at which the operating range of the first limiter-amplifier ends. The level-dividing circuit can be implemented, for example, by using resistors.

It has been observed that, in the intermediate-frequency circuit according to the invention, the total amplification of the limiter-amplifier can be limited to 50-60 dB, whereby the oscillation tendency of the VCO and the limiter-amplifier is eliminated. By means of two level detectors in parallel it is, however, possible to accomplish the required dynamism of over 75 dB. In principle the dynamism has no upper limit, since there can always be in parallel the necessary number of amplifiers and level-dividing circuits.

In principle it is thus possible to increase the dynamism of the level detector of an intermediate-frequency circuit by using an extra outside level-detection block suppressed by resistor division and to summate the level signals thus obtained.

Resistor division may well be replaced with, for example capacitive division, and the level signals received from the limiter-amplifier may be in the form of voltage or current, although current-form output is more practical for the reason that currents can be directly summated.

In practice the coupling of two limiter-amplifiers in parallel will suffice, and the level-dividing circuit is agreed upon case by case according to what is best suitable from the viewpoint of the bias voltages of the amplifier.

It is seen as a limitation of the intermediate-frequency circuit according to the invention that the maximum amplitude of the incoming intermediate-frequency signal must be, by the amount of the additional dynamism of the level detector, greater than it would be without the coupling in parallel. Since the incoming intermediate-frequency signal is usually received from a mixer, and in practice this signal has a certain maximum level, this provides an upper limit for the total dynamism of the level detector. However, as stated above, a total dynamism of over 75 dB can easily be obtained by means of such coupling, even at low operating voltages (under 6 V).

The invention is described below in greater detail in the form of an example and with reference to the accompanying drawing, in which
Figure 1 is a block diagram an already described conventional FM intermediate-frequency circuit,
Figure 2 depicts one embodiment of the FM intermediate-frequency circuit according to the invention, and
Figures 3-5 depict current curves relating to the operation of the circuit of Figure 2.

In Figure 2, reference numerals 2-4 indicate a phase detector, a loop filter, and a VCO, as in Figure 1. Compared with Figure 1, however, the limiter-amplifier 1 with the level detector belonging to it is implemented using two parallel limiter-amplifiers 1A and 1B.

Each limiter-amplifier 1A, 1B has its own level detector from which current-form signals IA, IB are obtained, and these signals are summated directly to form the level detection signal ITOT.

Figure 3 depicts the current signal IA of the level detector of the limiter-amplifier 1A, as a function of the input signal of the amplifier, i.e. the intermediate-frequency signal IF. The output signal IA increases linearly according to the input signal IF until the upper limit of the amplifier IA is reached.

By means of the resistor division R1, R2 the input signal of the parallel limiter-amplifier 1B is dropped so low that the lower limit of the operating range of the amplifier 1B is not reached until at that level of the signal IF at which the upper limit of the amplifier 1A is reached. The level detection signal IB is depicted as a function of the signal IF in Figure 4.

When the signals IA and IB are now summated, a level detection signal ITOT is obtained, which increases linearly along with the input signal IF within the range which corresponds to the combined operating ranges of the amplifiers 1A and 1B.

As stated above, the level-dividing circuit can also be implemented by methods other than resistor division, and there may be more than two limiter-amplifiers in parallel.

## Claims

1. An FM intermediate-frequency circuit into which there is integrated at least a first limiter-amplifier (1A), a level detector, and a phase-locked loop (2, 3, 4) containing a VCO oscillator (4), the level detector being incorporated into the limiter-amplifier (1A) to which an intermediate-frequency signal (IF) is applied, the output of said limiter amplifier (1A) being connected to the input of the phase-locked loop (2, 3, 4), **characterized** in that it has in parallel with the said limiter-amplifier (1A) at least one other limiter-amplifier (1B), in connection with which there is also a level detector, the level of the input signal of the other limiter-amplifier or the other limiter-amplifiers (1B) being dropped by means of a level-dividing circuit (R1, R2) as compared with that of the first limiter-amplifier (1A) and the signals (IA, IB) received from the level detectors being combined to form one level detection signal (ITOT).

2. An intermediate-frequency circuit according to Claim 1, **characterized** in that the level-dividing circuit is calibrated so that the operating range of the second limiter-amplifier (1B) begins at that intermediate-frequency signal level at which the operating range of the first limiter-amplifier (1A) ends.

3. An intermediate-frequency circuit according to Claim 1, **characterized** in that it has two limiter-amplifiers (1A, 1B) with their level detectors.

4. An intermediate-frequency circuit according to any of Claims 1-3, **characterized** in that the level-dividing circuit is implemented using resistors (R1, R2).

## Patentansprüche

1. FM-Zwischenfrequenzschaltung, in die wenigstens ein erster Begrenzerverstärker (1A), ein Pegeldetektor und ein Phasenregelkreis (2, 3, 4) mit einem VCO-Oszillator (4) integriert ist, wobei der Pegeldetektor im Begrenzerverstärker (1A) enthalten ist, an den ein Zwischenfrequenzsignal (IF) angelegt wird, und wobei der Ausgang des Begrenzerverstärkers (1A) mit dem Eingang des Phasenregelkreises (2, 3, 4) verbunden ist, dadurch **gekennzeichnet**, daß parallel zu dem genannten Begrenzerverstärker (1A) wenigstens ein weiterer Begrenzerverstärker (1B) und in Verbindung damit auch ein Pegeldetektor vorgesehen ist, wobei der Pegel des Eingangssignales des weiteren Begrenzerverstärkers oder der weiteren Begrenzerverstärker (1B) mittels einer Pegelteilerschaltung (R1, R2) im Vergleich zu dem des ersten Begrenzerverstärkers (1A) herabgesetzt ist, und wobei die von den Pegeldetektoren erhaltenen Signale (IA, IB) zur Bildung eines Pegeldetektionssignales (ITOT) kombiniert werden.

2. Zwischenfrequenzschaltung nach Anspruch 1, dadurch gekennzeichnet, daß die Pegelteilerschaltung so kalibriert ist, daß der Arbeitsbereich des zweiten Begrenzerverstärkers (1B) bei dem Zwischenfrequenzsignalpegel beginnt, bei dem der Arbeitsbereich des ersten Begrenzerverstärkers (1A) endet.

3. Zwischenfrequenzschaltung nach Anspruch 1, dadurch gekennzeichnet, daß sie zwei Begrenzerverstärker (1A, 1B) mit ihren Pegeldetektoren aufweist.

4. Zwischenfrequenzschaltung nach einem der Ansprüche 1 bis 3, dadurch gekennzeichnet, daß die Pegelteilerschaltung mit Widerständen (R1, R2) ausgeführt ist.

## Revendications

1. Circuit à fréquence intermédiaire pour modulation de fréquence dans lequel sont intégrés au moins un premier amplificateur-limiteur (1A), un détecteur de niveau, et une boucle à blocage de phase (2, 3, 4) contenant un oscillateur piloté par tension (4), le détecteur de niveau étant incorporé dans l'amplificateur-limiteur (1A) auquel est appliqué un signal de fréquence intermédiaire (FI), la sortie dudit amplificateur-limiteur (1A) étant reliée à l'entrée de la boucle à blocage de phase (2, 3, 4), caractérisé en ce qu'il comporte en parallèle avec ledit amplificateur-limiteur (1A) au moins un autre amplificateur-limiteur (1B), en connexion avec lequel il y a aussi un détecteur de niveau, le niveau du signal d'entrée de l'autre amplificateur-limiteur ou des autres amplificateurs-limiteurs (1B) étant amené à chuter au moyen d'un circuit diviseur de niveau (R1, R2) par rapport à celui du premier amplificateur-limiteur (1A) et les signaux (IA, IB) reçus en provenance des détecteurs de niveau étant combinés de manière à former un signal de détection de niveau (ITOT).

2. Circuit à fréquence intermédiaire selon la revendication 1, caractérisé en ce que le circuit diviseur de tension est étalonné de façon que la gamme opérationnelle du second amplificateur-limiteur (1B) commence au niveau du signal de fréquence intermédiaire auquel la gamme opérationnelle du premier amplificateur-limiteur (1A) se termine.

3. Circuit à fréquence intermédiaire selon la revendication 1, caractérisé en ce qu'il comporte deux amplificateurs-limiteurs (1A, 1B) avec leurs détecteurs de niveau.

4. Circuit à fréquence intermédiaire selon l'une quelconque des revendications 1-3, caractérisé en ce que le circuit diviseur de tension est mis en oeuvre en utilisant des résistances (R1, R2).
